# EUROPÄISCHE PATENTSCHRIFT

(11) **EP 2 553 038 B1**
(45) Veröffentlichungstag und Bekanntmachung des Hinweises auf die Patenterteilung: **20.07.2016**
(21) Anmeldenummer: 11701977.8
(22) Anmeldetag: 26.01.2011
(51) Int. Cl.: C09K 5/08

(54) **WÄRMELEITENDE ANORDNUNG ZWISCHEN ZWEI BAUTEILEN UND VERFAHREN ZUM HERSTELLEN EINER WÄRMELEITENDEN ANORDNUNG**
HEAT-CONDUCTING ARRANGEMENT BETWEEN TWO COMPONENTS AND PROCESS FOR PRODUCING A HEAT-CONDUCTING ARRANGEMENT
AGENCEMENT THERMOCONDUCTEUR ENTRE DEUX ÉLÉMENTS ET PROCÉDÉ DE FABRICATION D'UN AGENCEMENT THERMOCONDUCTEUR

(30) Priorität: 26.03.2010 DE 102010003330
(43) Veröffentlichungstag der Anmeldung: 06.02.2013
(73) Patentinhaber: Robert Bosch GmbH, 70442 Stuttgart (DE)
(72) Erfinder: SCHUETT, Klaus-Volker, 73249 Wernau (DE); WAHL, Ruben, 71394 Kernen (DE)
(86) Internationale Anmeldenummer: PCT/EP2011/051015
(87) Internationale Veröffentlichungsnummer: WO 2011/116997

(56) Entgegenhaltungen:
- US-A- 4 265 775
- US-A- 5 958 590
- US-A1- 2002 175 316
- XU J ET AL: "Synthesis and field emission properties of Cu dendritic nanostructures", PHYSICA E - LOW-DIMENSIONAL SYSTEMS AND NANOSTRUCTURES, ELSEVIER SCIENCE BV, NL, Bd. 42, Nr. 5, 1. März 2010 (2010-03-01), Seiten 1451-1455, XP026930592, ISSN: 1386-9477, DOI: DOI:10.1016/J.PHYSE.2009.11.115 [gefunden am 2009-12-05]
- JONGWOO PARK ET AL: "Propensity of Copper Dendrite Growth on Subassembly Package Components Used in Quad Flat Package", IEEE TRANSACTIONS ON DEVICE AND MATERIALS RELIABILITY, IEEE SERVICE CENTER, PISCATAWAY, NJ, US, Bd. 8, Nr. 2, 1. Juni 2008 (2008-06-01), Seiten 368-374, XP011206102, ISSN: 1530-4388

## Beschreibung

### Stand der Technik

Die Erfindung betrifft ein Verfahren zum Herstellen einer wärmeleitenden Anordnung nach dem Oberbegriff des Anspruchs 1. Ferner betrifft die Erfindung eine wärmeleitende Anordnung, die nach einem erfindungsgemäßen Verfahren hergestellt ist.

Ein Verfahren nach dem Oberbegriff des Anspruchs 1 ist aus der US 5,958,590 bekannt. Dort ist es vorgesehen, als Lötmaterial zur Verbindung bzw. zur Herstellung elektrisch leitfähiger Verbindungen dendritische Pulvermaterialien mit hoher Leitfähigkeit als Paste zu verwenden. Dabei sind in einer Matrix aus Polymermaterial als Trägermaterial elektrisch leitfähige Metallpartikel eingebunden, die, solange das Trägermaterial noch nicht fest ist, elektrisch leitfähige Brücken, sogenannte "Dendrite", bilden, die für einen relativ geringen elektrischen Widerstand der Verbindung sorgen.

Darüber hinaus ist aus der US 2002/0175316 A1 eine Anordnung mit wärmeleitenden Partikeln in einem wärmeleitenden Medium bekannt, wobei die wärmeleitenden Partikel als Dendrite ausgebildet sind, die die beiden Kontaktoberflächen der Bauteile wärmeleitend miteinander verbinden. Das Erzeugen der wärmeleitenden Verbindung durch die Dendrite wird durch Erwärmen des wärmeleitenden Mediums erzielt.

Ferner ist aus der US 4265775 A nicht-ausblühendes thixotropes wärmeleitendes dielektrisches Material bekannt, das einen flüssigen Organosilikon-Träger, Siliciumdioxidfasern und einen thermischen Füllstoff umfasst. Das Material weist hierbei Dendriten aus Zinkoxid auf.

Aus "Synthesis and field emission properties of Cu dendritic nanostructures", XU J et al., Physica E-Low-Dimensional Systems and Nanostructures, Elsevier 1. März 2010, Seiten 1451 - 1455 sind MAterialien aus Glas mit dedritischen Nanostrukturen aus Kupfer bekannt.

Aus "Propersity of Copper Dedrite Growth on Subassembly Package Components Used in Quad Flat Package", JONGWOO PARK et al, IEEE Transactions on Device and Materials reliability, IEEE Service Center, 1. Juni 2008, Seiten 368 - 374 sind Zusammensetzungen mit Dendriten aus Kupfer bekannt.

Weiterhin ist es aus dem Stand der Technik bereits allgemein bekannt, ein wärmeerzeugendes erstes Bauteil über ein Medium mit einem wärmeableitenden zweiten Bauteil, z.B. ein Kühlkörper, zu verbinden. Das Medium besteht zum Beispiel dabei entweder aus einer Paste, die nicht aushärtet, als sogenannter "Gap Filler", bei dem Anteile aushärten, oder als wärmeleitender Film oder wärmeleitender Klebstoff, wobei die beiden letztgenannten Medien in der Regel vollständig aushärten. Die genannten Materialien sind meist sehr hoch mit anorganischen Materialien, z.B. Silber, Aluminiumoxiden, Bornitriden oder Kohlenstoffen gefüllt. Zudem existieren sogenannte "Phase Change Materials" (PCM), deren Aggregatzustand sich in Abhängigkeit der Temperatur ändert, wobei eine Verbesserung der Benetzung der Bauteile erzielt wird. Bei den neuesten Entwicklungen hinsichtlich wärmeleitender Materialien werden Nanopartikel (z.B. Nanosilber, Carbon Nanotubes (CNT)) verwendet. All diese Materialien sind jedoch in Bezug auf eine Kombination folgender Anforderungen kritisch bzw. nicht optimal: Eine hohe thermische Leitfähigkeit bei hoher Flexibilität, eine hohe thermische Leitfähigkeit ohne Verwendung elektrisch leitfähiger Materialien, eine Reduktion der Wärmeübergangswiderstände durch eine gute thermische Anbindung an den jeweiligen Fügepartner.

### Offenbarung der Erfindung

Ausgehend von dem dargestellten Stand der Technik liegt der Erfindung die Aufgabe zugrunde, ein Verfahren zum Herstellen einer wärmeleitenden Anordnung zwischen zwei Bauteilen nach dem Oberbegriff des Anspruchs1 derart weiterzubilden, dass es ermöglicht wird, die Bildung der Dendrite unmittelbar durch die Bauteile, die an ihren Kontaktflächen in Wirkverbindung mit dem wärmeleitenden Medium angeordnet sind, gezielt zu beeinflussen. Diese Aufgabe wird bei einem Verfahren mit den Merkmalen des Anspruchs 1 dadurch gelöst, dass die beiden Bauteile zumindest an den Kontaktflächen zum wärmeleitenden Medium aus elektrisch leitendem Material, insbesondere aus Metall, bestehen. Dadurch wird die Möglichkeit geschaffen, durch Anlegen einer Spannung und eines damit verbundenen Stromflusses in dem wärmeleitenden Medium das gezielte Ausbilden der Dendrite zwischen den beiden Kontaktoberflächen zu ermöglichen.

Vorteilhafte Weiterbildungen des erfindungsgemäßen Verfahrens zum Herstellen der wärmeleitenden Anordnung zwischen zwei Bauteilen sowie der Anordnung selbst sind in den jeweiligen Unteransprüchen angegeben.

Besonders bevorzugt ist es, wenn zumindest das wärmeleitende Medium nach der Bildung der Dendrite zur Aushärtung einer Wärmebehandlung unterzogen wird. Dadurch wird der gewünschte feste Endzustand des wärmeleitenden Mediums erzielt, der eine feste Anbindung des wärmeleitenden Mediums an die Kontaktoberflächen der beiden Bauteile ermöglicht bzw. sicherstellt.

Bei einem wirtschaftlich sinnvollen Verfahren zum Herstellen der wärmeleitenden Anordnung wird vorgeschlagen, dass das wärmeleitende Medium auf die Kontaktoberfläche eines der beiden Bauteile aufgebracht wird und, dass anschließend das andere Bauteil mit seiner Kontaktoberfläche in Anlagekontakt mit dem wärmeleitenden Medium gebracht wird.

Insbesondere kann es dabei vorgesehen sein, dass das Aufbringen des wärmeleitenden Mediums auf die Kontaktoberfläche des einen Bauteils durch Stempeln, Dispensen oder durch Siebdruck erfolgt. Dabei richtet sich das verwendete Verfahren insbesondere nach der vorhandenen Oberflächenbeschaffenheit bzw. Topographie der Kontaktoberfläche des ersten Bauteils sowie der Größe derselben.

Falls die wärmeleitend zu verbindenden Bauteile nicht aus Metall bestehen und die Erfindung angewandt werden soll, ist es in einer Variante der Erfindung möglich bzw. denkbar, dass die beiden Bauteile an den Kontaktoberflächen eine metallische Beschichtung oder eine metallische Schicht aufweisen.

Insbesondere ist es vorgesehen, dass das erste Bauteil ein elektrisches Bauelement und das zweite Bauteil ein Kühlelement ist. Dabei wird durch die erfindungsgemäße wärmeleitende Anordnung ein optimaler Wärmefluss zwischen dem elektrischen Bauteil und dem Kühlelement ermöglicht.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: einen Längsschnitt durch eine Anordnung zweier wärmeleitend zu verbindenden Bauteile unter Verwendung eines wärmeleitenden Mediums im Ausgangszustand und
- Fig. 2: einen Längsschnitt durch die Anordnung gemäß Fig. 1, bei der die Anordnung bzw. das wärmeleitende Medium im Endzustand Dendrite aufweist.

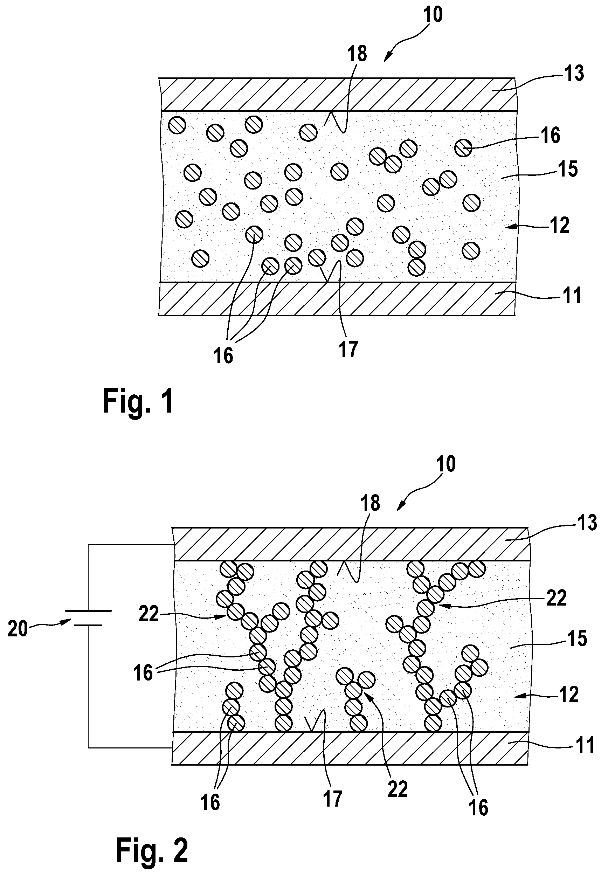

In der Fig. 1 ist eine Anordnung 10, bestehend aus einem ersten Bauteil 11, einem wärmeleitenden Medium 12 und einem zweiten Bauteil 13 dargestellt. Hierbei kann es sich bei dem ersten Bauteil 11 zum Beispiel, aber nicht einschränkend, um ein wärmeerzeugendes elektrisches oder elektronisches Bauteil, z.B. einen Leistungstransistor, einen IC oder ähnliches, handeln. Das zweite Bauteil 13 wiederum ist beispielhaft, jedoch nicht einschränkend, als wärmeableitendes Bauteil, z.B. als Kühlkörper, ausgebildet, das die vom ersten Bauteil 11 erzeugte Wärme an die Umgebung abgeben soll.

Das wärmeleitende Medium besteht aus einem Trägermaterial 15, insbesondere in Form einer Polymermatrix, in der im Ausgangszustand, wie dieser in der Fig. 1 dargestellt ist, Metallsalze in Form von Metallionen 16, eingemischt sind, die mehr oder weniger gleichmäßig in dem Trägermaterial 15 verteilt angeordnet sind. Als Metallionen 16 werden Kupfer- und/oder Eisen- und/oder Aluminium- und/oder Silberionen verwendet. Hierbei besteht zwischen den einzelnen Metallionen 16 in der Regel zunächst kein Kontakt. Wesentlich ist auch, dass das wärmeleitende Medium 12 im Ausgangszustand flüssig bzw. pastös ausgebildet ist, wodurch eine Bewegung der Metallionen 16 möglich ist.

Zum Herstellen der Anordnung 10 wird das wärmeleitende Medium 12 zunächst zum Beispiel auf das erste Bauteil 11 aufgebracht. Dies kann insbesondere durch Stempeln, Dispensen oder durch Siebdruck erfolgen, je nach wirtschaftlichen oder sonstigen Erfordernissen, die es ermöglichen, das wärmeleitende Medium 12 in gewünschter Weise auf die Kontaktoberfläche 17 des ersten Bauteils 11 aufzubringen. Anschließend wird das zweite Bauteil 13 mit seiner dem wärmeleitenden Medium 12 zugewandten Kontaktoberfläche 18 in Wirkverbindung mit dem wärmeleitenden Medium 12 gebracht, indem das zweite Bauteil 13 mit seiner Kontaktoberfläche 18 z.B. auf das wärmeleitende Medium 12 aufgedrückt wird.

Nachdem die Anordnung 10 gemäß der Fig. 1 ausgebildet ist, wird in einem zweiten Schritt eine elektrische Spannung an die beiden Bauteile 11 und 13 angelegt. Dies ist in der Fig. 2 dargestellt. Für den Fall, dass die beiden Bauteile 11 und 13 aus elektrisch leitendem Material, insbesondere aus Metall, beispielsweise Kupfer, bestehen, kann dies durch direktes Verbinden der Bauteile 11 und 13 mit einer Spannungsquelle 20 erfolgen. Bestehen die beiden Bauteile 11 und 13 jedoch aus elektrisch schlecht oder nicht leitendem Material, so ist es vorteilhaft bzw. erforderlich, dass die beiden Bauteile 11 und 13 an ihren Kontaktoberflächen 17 und 18 mit einer metallischen Beschichtung oder einer metallischen Schicht, beispielsweise aus Kupfer, versehen sind, die dann mit der Spannungsquelle 20 verbunden ist.

Durch das Anlegen der Spannung an die beiden Bauteile 11 und 13 (bzw. an die elektrisch leitenden Kontaktoberflächen 17 und 18 der beiden Bauteile 11 und 13) bilden die Metallionen 16 innerhalb des wärmeleitenden Mediums 12 Dendrite 22 aus, die eine direkte Verbindung zwischen den beiden Kontaktoberflächen 17 und 18 über die Metallionen 16 und damit auch zwischen den beiden Bauteilen 11 und 13, ermöglichen. Durch die Dendrite 22 werden somit die beiden Kontaktoberflächen 17 und 18 unmittelbar wärmeleitend verbunden, sodass eine vom ersten Bauteil 11 erzeugte Wärme auf direktem Weg über das wärmeleitende Medium 12 bzw. die Dendrite 22 an das zweite Bauteil 13 abgeleitet wird.

Bereits beim Anlegen der Spannung bzw. bei der Bildung der Dendrite 22 härtet das wärmeleitende Medium 12 aus bzw. beginnt auszuhärten. Zur Beschleunigung des Aushärteprozesses ist es sinnvoll bzw. vorteilhaft, die Anordnung 10 anschließend in einem Ofen einer Wärmebehandlung zu unterziehen. Dabei härtet das wärmeleitende Material 12 vollständig aus, sodass eine optimale Wärmeleitfähigkeit erzielt wird.

Die soweit dargestellte bzw. beschriebene Anordnung 10 kann in vielfältiger Art und Weise abgewandelt bzw. modifiziert werden. So ist es beispielsweise auch denkbar, dass die Bauteile 11 und 13 nicht, wie dargestellt, ebene bzw. glatte Kontaktoberflächen 17 und 18 aufweisen, sondern dass diese andersartig ausgebildet sind. In diesem Fall kann sich das wärmeleitende Medium 12 durch seine im Ausgangszustand pastöse bzw. flüssige Form problemlos an die jeweiligen Oberflächen der Bauteile 11 und 13 anschmiegen bzw. z.B. Bauteilelücken ausfüllen.

## Patentansprüche

1. Verfahren zum Herstellen einer wärmeleitenden Anordnung (10) zwischen zwei Bauteilen (11, 13), bei der ein wärmeleitendes Medium (12) zwischen Kontaktoberflächen (17, 18) der Bauteile (11, 13) angeordnet wird, wobei das wärmeleitende Medium (12) zunächst flüssig oder pastös und nach einem Aushärteprozess fest ausgebildet ist,
**dadurch gekennzeichnet,**
**dass** an den den Bauteilen (11, 13) zugewandten Kontaktoberflächen (17, 18) des wärmeleitenden Mediums (12) zumindest mittelbar eine elektrische Spannung angelegt wird, worauf in dem wärmeleitenden Medium (12) durch Metallbestandteile, insbesondere durch Metallionen (16) Dendrite (22) gebildet werden, die die Kontaktoberflächen (17, 18) der beiden Bauteile (11, 13) wärmeleitend miteinander verbinden.

2. Verfahren nach Anspruch 1,
**dadurch gekennzeichnet,**
**dass** die Bauteile (11, 13) zumindest an den Kontaktoberflächen (17, 18) mit dem wärmeleitenden Medium (12) elektrisch leitend ausgebildet sind und, dass die Spannung an die Bauteile (11, 13) angelegt wird.

3. Verfahren nach Anspruch 1 oder 2,
**dadurch gekennzeichnet,**
**dass** zumindest das wärmeleitende Medium (12) nach der Bildung der Dendrite (22) zur Aushärtung einer Wärmebehandlung unterzogen wird.

4. Verfahren nach einem der Ansprüche 1 bis 3,
**dadurch gekennzeichnet,**
**dass** das wärmeleitende Medium (12) auf die Kontaktoberfläche (17, 18) eines der beiden Bauteile (11, 13) aufgebracht wird und, dass anschließend das andere Bauteil (11, 13) mit seiner Kontaktoberfläche (17, 18) in Anlagekontakt mit dem wärmeleitenden Medium (12) gebracht wird.

5. Verfahren nach Anspruch 4,
**dadurch gekennzeichnet,**
**dass** das Aufbringen des wärmeleitenden Mediums (12) auf die Kontaktoberfläche (17, 18) des einen Bauteils (11, 13) durch Stempeln, Dispensen oder durch Siebdruck erfolgt.

6. Wärmeleitende Anordnung (10) zwischen zwei Bauteilen (11, 13), hergestellt nach einem Verfahren nach einem der Ansprüche 1 bis 5, mit einem Wärme erzeugenden ersten Bauteil (11) und einem zweiten Bauteil (13) zur Ableitung der Wärme des ersten Bauteils (11), wobei die beiden Bauteile (11, 13) mittels eines wärmeleitenden Mediums (12) miteinander in Wirkverbindung angeordnet sind, wobei das wärmeleitende Medium (12) Metallionen (16) enthält, wobei die Metallionen (16) Kupfer- oder Eisen- oder Aluminium- oder Silberionen sind, die in einem Trägermaterial (15), insbesondere in einer Polymermatrix, angeordnet sind, und wobei das wärmeleitende Medium (12) in einem Endzustand aus den Metallionen (16) ausgebildete Dendrite (22) aufweist, die mit Kontaktoberflächen (17, 18) der beiden Bauteile (11, 13) wärmeleitend verbunden sind.

7. Anordnung nach Anspruch 6,
**dadurch gekennzeichnet,**
**dass** die beiden Bauteile (11, 13) an den Kontaktoberflächen (17, 18) eine metallische Beschichtung oder eine metallische Schicht aufweisen.

8. Anordnung nach Anspruch 6 oder 7,
**dadurch gekennzeichnet,**
**dass** das erste Bauteil (11) ein elektrisches oder elektronisches Bauelement und das zweite Bauteil (13) ein Kühlelement ist.

## Claims

1. Method for producing a heat-conducting arrangement (10) between two components (11, 13), in which a heat-conducting medium (12) is arranged between contact surfaces (17, 18) of the components (11, 13), wherein the heat-conducting medium (12) is initially liquid or paste-like and is solid after a curing process,
**characterized in that**
an electric voltage is applied at least indirectly to the contact surfaces (17, 18), facing the components (11, 13), of the heat-conducting medium (12), whereupon dendrites (22) are formed in the heat-conducting medium (12) by metal constituents, in particular by metal ions (16), which dendrites connect the contact surfaces (17, 18) of the two components (11, 13) to one another in a heat-conducting manner.

2. Method according to Claim 1,
**characterized in that**
the components (11, 13) are formed so as to be electrically conductive, at least at the contact surfaces (17, 18) with the heat-conducting medium (12), and **in that** the voltage is applied to the components (11, 13).

3. Method according to Claim 1 or 2,
**characterized in that** at least the heat-conducting medium (12) is subjected to heat treatment for curing after formation of the dendrites (22).

4. Method according to one of Claims 1 to 3,
**characterized in that**
the heat-conducting medium (12) is applied to the contact surface (17, 18) of one of the two components (11, 13), and **in that** subsequently the other component (11, 13) is brought into contact, by its contact surface (17, 18), with the heat-conducting medium (12).

5. Method according to Claim 4,
**characterized in that**
application of the heat-conducting medium (12) onto the contact surface (17, 18) of the first component (11, 13) is performed by stamping, dispensing or by screen printing.

6. Heat-conducting arrangement (10) between two components (11, 13), produced according to a method according to one of Claims 1 to 5, with a heat-generating first component (11) and a second component (13) for dissipating the heat of the first component (11), wherein the two components (11, 13) are actively connected to one another by means of a heat-conducting medium (12), wherein the heat-conducting medium (12) contains metal ions (16), wherein the metal ions (16) are copper ions, iron ions, aluminium ions or silver ions which are arranged in a carrier material (15), in particular in a polymer matrix, and wherein the heat-conducting medium (12) in a final state has dendrites (22) which are formed from the metal ions (16) and which are connected to contact surfaces (17, 18) of the two components (11, 13) in heat-conducting fashion.

7. Arrangement according to Claim 6,
**characterized in that**
the two components (11, 13) have a metallic coating or a metallic layer on the contact surfaces (17, 18).

8. Arrangement according to Claim 6 or 7,
**characterized in that**
the first component (11) is an electric or electronic component and the second component (13) is a cooling element.

## Revendications

1. Procédé pour réaliser entre deux composants (11, 13) un ensemble caloporteur (10) dans lequel un fluide caloporteur (12) est disposé entre des surfaces de contact (17, 18) des composants (11, 13), le fluide caloporteur (12) étant d'abord liquide ou pâteux et devenant solide après une opération de durcissement, **caractérisé en ce que**
une tension électrique est appliquée au moins indirectement sur les surfaces de contact (17, 18) du fluide caloporteur (12) tournées vers les composants (11, 13), suite à quoi des dendrites (22) qui relient l'une à l'autre de manière thermiquement conductrice les surfaces de contact (17, 18) des deux composants (11, 13) sont formés dans le fluide caloporteur (12) par des composants métalliques et en particulier par des ions métalliques (16).

2. Procédé selon la revendication 1, **caractérisé en ce que** les composants (11, 13) sont électriquement conducteurs au moins sur leurs surfaces de contact (17, 18) avec le fluide caloporteur (12) et **en ce que** la tension est appliquée sur les composants (11, 13).

3. Procédé selon les revendications 1 ou 2, **caractérisé en ce qu'**au moins le fluide caloporteur (12) subit un traitement thermique après la formation des dendrites (22) de durcissement.

4. Procédé selon l'une des revendications 1 à 3, **caractérisé en ce que** le fluide caloporteur (12) est appliqué sur la surface de contact (17, 18) de l'un des deux composants (11, 13) et **en ce qu'**ensuite l'autre composant (11, 13) est mis en contact par sa surface de contact (17, 18) avec le fluide caloporteur (12).

5. Procédé selon la revendication 4, **caractérisé en ce que** l'application du fluide caloporteur (12) sur la surface de contact (17, 18) de l'un des composants (11, 13) s'effectue par tamponnage, enduction ou sérigraphie.

6. Ensemble caloporteur (10) entre deux composants (11, 13), réalisé à l'aide d'un procédé selon l'une des revendications 1 à 5 et présentant un premier composant (11) dégageant de la chaleur et un deuxième composant (13) qui évacue la chaleur du premier composant (11), les deux composants (11, 13) coopérant l'un avec l'autre au moyen d'un fluide caloporteur (12), le fluide caloporteur (12) contenant des ions métalliques (16), les ions métalliques (16) étant des ions de cuivre, de fer, d'aluminium ou d'argent disposés dans un matériau de support (15) et en particulier une matrice polymère, le fluide caloporteur (12) présentant dans un état final des dendrites (22) formés des ions métalliques (16) et reliés aux surfaces de contact (17, 18) des deux composants (11, 13) de manière à conduire la chaleur.

7. Ensemble selon la revendication 6, **caractérisé en ce que** les deux composants (11, 13) présentent sur les surfaces de contact (17, 18) un revêtement métallique ou une couche métallique.

8. Ensemble selon les revendications 6 ou 7, **caractérisé en ce que** le premier composant (11) est un composant électrique ou électronique et le deuxième composant (13) un élément de refroidissement.
